# DEMANDE DE BREVET EUROPEEN

(11) **EP 0 853 244 A2**
(43) Date de publication de la demande: **15.07.1998**
(21) Numéro de dépôt: 97403181.7
(22) Date de dépôt: 30.12.1997
(51) Int. Cl.: G01R 31/327

(54) **Outil de test pour cellule moyenne et haute tension**

(30) Priorité: 09.01.1997 FR 9700140
(71) Demandeur: GEC ALSTHOM T ET D SA, 75116 Paris (FR)
(72) Inventeur: Friaud, Marc, 69830 St Georges De Reneins (FR)
(74) Mandataire: Feray, Valérie

(57) **Abrégé**

L'outil de test se présente sous la forme d'une valise transportable équipée d'un moyen de raccordement (6) complémentaire à un connecteur multi-broches d'un compartiment de contrôle/commande d'une cellule moyenne ou haute tension. Un ensemble d'organes témoins (7) sont connectés au moyen de raccordement pour signaler respectivement la présence ou l'absence d'un signal basse tension de commande sur une broche correspondante du connecteur. Un ensemble de commutateurs (8) sont connectés au moyen de raccordement pour fournir ou ne pas fournir à des broches correspondantes du connecteur des signaux d'état basse tension. Un circuit de simulation du comportement d'un appareillage de cellule est connecté au moyen de raccordement de telle façon à recevoir les signaux basse tension de commande d'enclenchement ou de déclenchement et produire le signal basse tension indicatif de l'état enclenché ou déclenché de l'appareillage. Un tel outil de test contribue à faciliter la maintenance d'une telle cellule sur site.

## Description

L'invention concerne les cellules moyenne et haute tension utilisées pour constituer des tableaux de distribution d'énergie électrique.

L'invention porte plus particulièrement sur un outil de test de bon fonctionnement pour une cellule moyenne et haute tension.

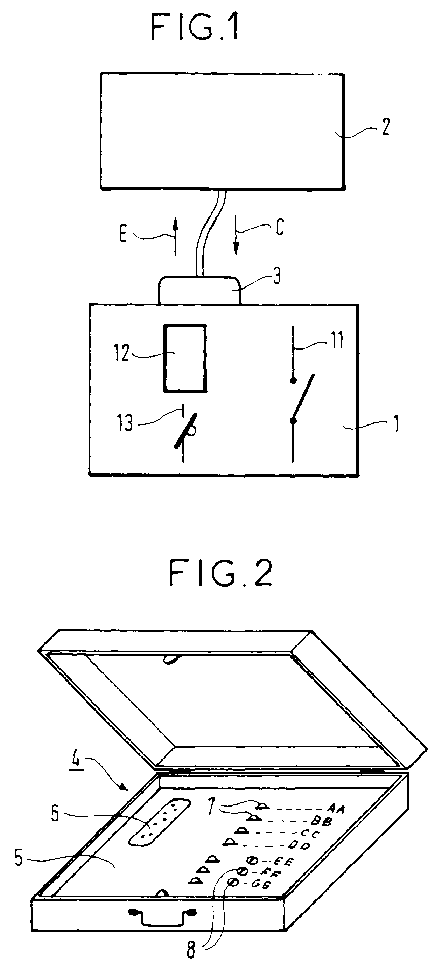

La figure 1 illustre très schématiquement sous forme d'un schéma blocs très simplifié, le principaux éléments d'une telle cellule. Celle-ci comprend classiquement, outre les câbles et le jeu de barres d'alimentation, un appareillage 1 incluant par exemple un disjoncteur tel que 11, des organes de manoeuvre du disjoncteur représentés par 12 comme des relais, moteurs, bobines d'enclenchement et bobines de déclenchement et des capteurs 13 fournissant des signaux basse tension d'état indicatifs de la présence de défauts dans la partie haute tension du circuit du disjoncteur et de l'état enclenché ou déclenché de celui-ci.

La cellule comporte aussi un compartiment de contrôle/commande 2 sous la forme d'un coffret venant se placer au dessus de l'appareillage et se connecter à celui-ci, ce compartiment renfermant des circuits de commande et de contrôle de l'appareillage. En particulier ce compartiment est chargé d'élaborer les signaux de commande C de l'appareillage qu'il lui transmet va un connecteur standard multi-broches 3 et reçoit de l'appareillage les signaux basse tension d'état E via ce connecteur. Les signaux de commande C aboutissent soit directement, soit au travers de relais ou de semi-conducteurs aux bobines d'enclenchement et de déclenchement de l'appareil. Le compartiment de contrôle/commande fournit aussi à l'appareillage haute tension les polarités d'alimentation nécessaires aux motorisations, relais et bobines.

Le connecteur 3 est standardisé dans la mesure où ses broches sont affectées respectivement à la transmission de signaux bien spécifiques quel que soit l'appareillage qui est sous contrôle/commande ce qui permet une interchangeabilité des compartiments de contrôle/commande dans les cellules et de l'appareillage.

Le compartiment de contrôle/commande renferme aussi toute une logique pour mettre en oeuvre des séquences d'interverrouillage électrique. Ces séquences sont telles qu'elle permettent de faire fonctionner plusieurs cellules d'un tableau en interdisant certaines combinaisons d'enclenchement des appareillages de ces cellules. Cette logique tient compte des signaux de commande d'enclenchement ou de déclenchement transmis à chaque appareillage et des signaux d'état indicatifs de l'état enclenché ou déclenché des appareillages.

Le but de l'invention est de proposer un outil simple pour tester le bon fonctionnement d'un tel compartiment de contrôle/commande d'une cellule moyenne ou haute tension et/ou de discriminer le mauvais fonctionnement du compartiment de contrôle/commande et le mauvais fonctionnement de l'appareillage dans une cellule.

A cet effet, l'invention a pour objet un outil de test pour une cellule moyenne ou haute tension, cette cellule comprenant un appareillage ayant un état enclenché quand il reçoit un signal basse tension de commande d'enclenchement et un état déclenché quand il reçoit un signal basse tension de commande de déclenchement et restituant en sortie un signal basse tension d'état indicatif de son état enclenché ou déclenché, et un compartiment de contrôle/commande fournissant à l'appareillage, à travers un connecteur multi-broches, des signaux basse tension de commande incluant les signaux de commande d'enclenchement et de déclenchement et recevant de cet appareillage, à travers ce connecteur multi-broches, des signaux basse tension d'état fournis par des capteurs incluant au moins le signal basse tension représentatif de l'état enclenché ou déclenché de l'appareillage, cet outil étant équipé d'un moyen de raccordement complémentaire au connecteur multi-broches, d'un ensemble d'organes témoins connectés au moyen de raccordement pour signaler respectivement la présence ou l'absence d'un signal basse tension de commande sur une broche correspondante du connecteur, d'un ensemble de contacteurs connectés au moyen de raccordement pour fournir ou ne pas fournir à des broches correspondantes du connecteur des signaux d'état basse tension, les organes témoins et les commutateurs étant disposés sur un support portant un marquage, l'outil comprenant en outre un circuit connecté au moyen de raccordement de telle façon à recevoir les signaux basse tension de commande d'enclenchement ou de déclenchement, ce circuit étant agencé pour produire sur une sortie le signal basse tension indicatif de l'état enclenché ou déclenché de l'appareillage en simulant le fonctionnement de cet appareillage.

Selon un mode de réalisation préféré de l'invention, cet outil est conçu sous la forme d'une valise transportable. Un tel outil de test est d'une conception très simple. En cas de défaut de fonctionnement d'une cellule, on le connecte au compartiment de contrôle/commande de cette cellule pour vérifier que les signaux basse tension de ce compartiment sont correctement générés. Si tel est le cas, on peut rapidement en déduire un défaut de fonctionnement de l'appareillage. Dans le cas contraire, le défaut de fonctionnement du compartiment peut facilement être localisé à l'aide des organes témoins

Du fait de la présence du circuit simulateur, il peut être substitué à un appareillage d'une cellule faisant partie d'un tableau de distribution d'énergie sans compromettre le fonctionnement du tableau. Il facilite ainsi la maintenance sur site des cellules du tableau et le contrôle de séquences d'interverrouillage dans le tableau.

Les commutateurs de l'outil de test remplacent les capteurs de défauts et permettent de forcer certains signaux ce qui augmente les possibilités de contrôle de bon fonctionnement d'un compartiment de contrôle/commande de cellule. Il peut servir aussi à contrôler le bon fonctionnement d'un compartiment de contrôle/commande juste après sa fabrication sans qu'il soit nécessaire de le raccorder à un appareillage.

Un exemple de réalisation de l'outil de test selon l'invention est décrit ci-après en relation avec les dessins.

La figure 1 montre de façon très schématique les principaux éléments d'une cellule moyenne ou haute tension.

La figure 2 illustre une réalisation de cet outil de test sous la forme d'une valise transportable.

La figure 3 montre de façon très schématique, les éléments de cet outil.

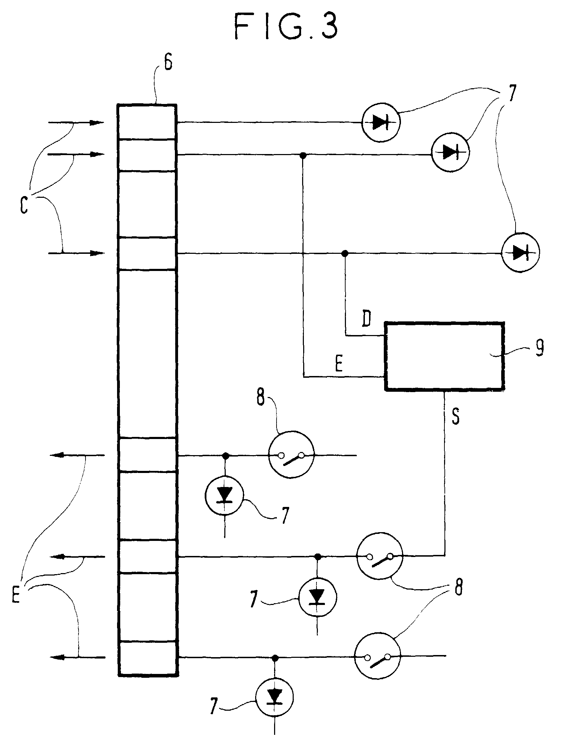

Figures 2 et 3, l'outil de test selon l'invention se présente plus particulièrement sous la forme d'une valise transportable 4 montrée ici avec son couvercle ouvert et dans le fond de laquelle est disposée une plaque support 5.

Un moyen de raccordement 6 complémentaire au connecteur multi-broches 3 est monté sur la plaque support 5, ce moyen de raccordement étant destiné à recevoir le connecteur pour établir une connexion point à point. Il s'agit typiquement d'une prise multi-points.

Chaque point de la prise 6 est connecté à un organe témoin, telle qu'une diode électroluminescente 7, permettant un contrôle visuel ou analogue de la présence ou de l'absence d'un signal basse tension de commande C ou d'état E sur une broche correspondante du connecteur 3.

Chaque point de la prise 6 en contact avec une broche du connecteur 3 par laquelle passe un signal basse tension d'état E est connecté à un commutateur 8, tel qu'un bouton poussoir, de façon à pouvoir forcer la présence ou l'absence d'un tel signal sur cette broche.

L'ensemble des organes témoins 7 et des commutateurs 8 sont montés sur la plaque 5 qui porte par ailleurs un marquage symbolisé par AA,BB, ..GG. Ce marquage sert à identifier les signaux basse tension qui passent sur les broches du connecteur 3. La plaque support peut avantageusement être une plaque de circuit imprimé.

Enfin comme illustré sur la figure 3, un circuit 9 est par ailleurs connecté à la prise 6 de telle façon à recevoir les signaux basse tension de commande d'enclenchement E ou de déclenchement D, ce circuit étant agencé pour produire sur une sortie le signal basse tension S indicatif de l'état enclenché ou déclenché de l'appareillage en simulant exactement le fonctionnement de cet appareillage lorsqu'il reçoit ces signaux de commande. Ce circuit 9 peut être une bascule bistable dont la sortie S passe soit à un 1 par exemple sur réception d'un signal basse tension E de commande d'enclenchement et à 0 sur réception d'un signal basse tension D de commande de déclenchement. Ce circuit 9 peut aussi être un microprocesseur ce qui permet de raccorder un écran d'affichage à la valise en vue d'un contrôle plus élaboré du fonctionnement du compartiment de contrôle/commande.

Du fait que l'outil de test est alimenté par le compartiment de contrôle/commande à tester, des adaptateurs électriques (non représentés) sont par ailleurs prévus dans cet outil pour adapter le niveau de tension des signaux basse tension reçus sur la prise 6 en fonction des caractéristiques électriques des éléments (organes témoins, commutateurs, ...) de l'outil de test puisque le niveau de tension de ces signaux dépend de la source d'alimentation du compartiment de contrôle/commande.

Un tel outil de test contribue à améliorer le flux du contrôle des compartiments de contrôle/commande en usine lors de leur fabrication car cette opération ne nécessite plus la présence d'un appareillage. Il contribue aussi à faciliter la maintenance de cellules sur site. Avec un tel outil, il est possible de vérifier les automatismes d'un tableau, en particulier les séquences d'interverrouillage même quand un ou l'ensemble des appareillages sont débrochés.

## Revendications

1. Un outil de test pour une cellule moyenne ou haute tension, cette cellule comprenant un appareillage (1) ayant un état enclenché quand il reçoit un signal basse tension de commande d'enclenchement et un état déclenché quand il reçoit un signal basse tension de commande de déclenchement et restituant en sortie un signal basse tension d'état indicatif de son état enclenché ou déclenché, et un compartiment de contrôle/commande (2) fournissant à l'appareillage, à travers un connecteur multi-broches (3), des signaux basse tension de commande incluant les signaux de commande d'enclenchement et de déclenchement et recevant de cet appareillage, à travers ce connecteur multi-broches, des signaux basse tension d'état fournis par des capteurs (13) incluant au moins le signal basse tension représentatif de l'état enclenché ou déclenché de l'appareillage, cet outil étant équipé d'un moyen de raccordement (6) complémentaire au connecteur multi-broches, d'un ensemble d'organes témoins (7) connectés au moyen de raccordement pour signaler respectivement la présence ou l'absence d'un signal basse tension de commande sur une broche correspondante du connecteur, d'un ensemble de commutateurs (8) connectés au moyen de raccordement pour fournir ou ne pas fournir à des broches correspondantes du connecteur des signaux d'état basse tension, les organes témoins et les commutateurs étant disposés sur un support (5) portant un marquage (AA,BB,...GG), l'outil comprenant en outre un circuit (9) connecté au moyen de raccordement de telle façon à recevoir les signaux basse tension de commande d'enclenchement ou de déclenchement, ce circuit étant agencé pour produire sur une sortie le signal basse tension (S) indicatif de l'état enclenché ou déclenché de l'appareillage en simulant le fonctionnement de cet appareillage.

2. L'outil selon la revendication 1 conçu sous la forme d'une valise transportable (4).

3. L'outil selon l'une des revendications 1 ou 2, dans lequel le circuit (9) est une bascule bistable.

4. L'outil selon l'une des revendications 1 ou 2, dans lequel le circuit (9) est un microprocesseur.

5. L'outil selon l'une des revendications 1 à 4, dans lequel le support (5) est une plaque de circuit imprimé.
